# EUROPÄISCHE PATENTSCHRIFT

(11) **EP 3 295 530 B1**
(45) Veröffentlichungstag und Bekanntmachung des Hinweises auf die Patenterteilung: **15.05.2019**
(21) Anmeldenummer: 16733276.6
(22) Anmeldetag: 10.05.2016
(51) Int. Cl.: H02G 15/02, H02G 15/04, G01R 31/12, H01B 3/46, H01B 9/00, H02G 1/14, H02G 15/00, H02G 15/064, H02G 15/068, H02G 15/184

(54) **HOCHSPANNUNGSKABELGARNITUR UND VERFAHREN ZUM HERSTELLEN EINER HOCHSPANNUNGSKABELGARNITUR**
SET OF HIGH-VOLTAGE CABLES AND METHOD FOR PRODUCING A SET OF HIGH-VOLTAGE CABLES
GARNITURE DE CÂBLE HAUTE TENSION ET PROCÉDÉ DE RÉALISATION D'UNE GARNITURE DE CÂBLE HAUTE TENSION

(30) Priorität: 12.05.2015 DE 102015107479
(43) Veröffentlichungstag der Anmeldung: 21.03.2018
(73) Patentinhaber: IPH Institut "Prüffeld für elektrische Hochleistungstechnik" GmbH, 12681 Berlin (DE); Polymerics GmbH, 12681 Berlin (DE); HPS GmbH Berlin Hochspannungsprüfungen & Beratung, Anglersiedlung Nr. 13 (DE); BAM Bundesanstalt für Materialforschung und -prüfung, 12205 Berlin (DE)
(72) Erfinder: HEIDMANN, Gerd, 10319 Berlin (DE); LEISTNER, Aniela, 15366 Hoppegarten OT Birkenstein (DE); SIEBLER, Daniel, 10439 Berlin (DE); ROHWETTER, Philipp, 33611 Bielefeld (DE); HABEL, Wolfgang, 13125 Berlin (DE); PLATH, Ronald, 13503 Berlin (DE); LEISTNER, Andre, 15366 Hoppegarten, OT Birkenstein (DE)
(74) Vertreter: Müller, Wolfram Hubertus
(86) Internationale Anmeldenummer: PCT/DE2016/000205
(87) Internationale Veröffentlichungsnummer: WO 2016/180396

(56) Entgegenhaltungen:
- EP-A2- 1 026 704
- EP-A2- 2 472 688
- DE-A1- 2 050 581

## Beschreibung

Die vorliegende Erfindung betrifft eine Hochspannungskabelgarnitur, insbesondere eine Kabelmuffe und einen Endverschluss, sowie eine zugehöriges Herstellungsverfahren.

In elektrischen Anlagen zur Energieversorgung kommt es auf Grund von schädigenden Einflüssen auf die Hochspannungsgarnitur und Alterungserscheinungen der polymeren Isolierungen immer wieder zu Ausfällen. Hauptsächlich werden diese Ausfälle durch Teilentladungen verursacht. Derartige Ausfälle können aber auch durch Montagefehler bedingt bzw. befördert werden, da beispielsweise kleinste, während der Montage unbeabsichtigt in die Hochspannungsgarnitur eingebrachte Partikel im Betrieb zu extremen lokalen Feldüberhöhungen führen können. Während der Teilentladungen entstehen im Isolierstoff sogenannte Teilentladungsbäumchen, die im Laufe der Zeit wachsen und schließlich zu einem elektrischen Durchschlag führen, falls die betroffenen Anlagen nicht rechtzeitig abgeschaltet werden. Teilentladungen in Isolierungen von Kabelgarnituren, wie Endverschlüsse und Kabelmuffen für Starkstromkabel bzw. Hochspannungskabel, können in fortgeschrittenem Stadium daher zur Totalzerstörung (Explosion) der Kabelgarnituren und zu Netzausfällen führen. Auf Grund der mit dem Durchschlag verbundenen hohen Energiefreisetzung können dabei weitere Teile der Anlagen beschädigt werden. Die durch diese zwar eher seltenen Ereignisse verursachten Schäden können daher beträchtlich sein.

Gemäß der gängigen Vorstellung verändert sich ein polymeres Isoliermaterial im Hochspannungswechselfeld in mehreren Stufen. Die Prozesse, die in Dielektrika unter Gleichspannungsbelastung zu Teilentladungen führen, könnten ähnlich ablaufen, werden im Folgenden aber nicht detailliert beschrieben. Typischerweise wird in Hochspannungswechselfeldern von einem dreistufigen phänomenologischen Alterungsmodell polymerer Isolierungen ausgegangen, das den Teilentladungsprozess als dritte Stufe einschließt. In der ersten Stufe erfolgt eine Bereitstellung von Ladungsträgern, die je nach Material und Feldverteilung durch eine charakteristische kritische Feldstärke gekennzeichnet ist. Dieser Prozess kann im Isolierstoffvolumen überall dort ablaufen, wo infolge z.B. herstellungsbedingter Inhomogenitäten die kritische Feldstärke überschritten wird. Er kann aber auch an der Grenzfläche zum stromführenden Leiter stattfinden. Die zweite Modellstufe ist dadurch charakterisiert, dass mit dem Beginn der Ladungsträgerinjektion ein Energietransfer vom elektrischen Feld über die injizierten Ladungsträger auf die Polymermatrix stattfindet. Materialabhängige und herstellungsbedingte Inhomogenitäten spielen hierbei eine zentrale Rolle, da sie als Startpunkte der nun einsetzenden irreversiblen Schädigungsmechanismen dienen. Durch die Ladungsträgerinjektion in den jeweiligen Halbschwingungen des Hochspannungswechselfelds kommt es zu einem Raumladungsaufbau in Haftstellen. Dabei kann es zu Elektrolumineszenzerscheinungen kommen. Das Auftreten von Elektrolumineszenz in dieser Phase kann durch sogenannte "hot-electron"-Prozessen, durch Anregung von Molekülen, und durch Ladungsträgerrekombinationen verursacht werden. Welche dieser Prozesse ggf. dominieren, ist vom Material abhängig. Der Energietransfer über die injizierten Ladungsträger führt zu irreversiblen chemischen, mechanischen und thermischen Veränderungen des Polymergefüges. Dabei wird der lokale Feldstärkeverlauf durch Raumladungsrückwirkungen typischerweise stark beeinflusst. Anschließend kann es zur Ausbildung von Mikrohohlräumen kommen, die mit der Emission akustischer Signale verbunden sein können und in denen nach Überschreiten einer kritischen Größe Teilentladungen zünden, womit die dritte Stufe erreicht ist. Durch elektrochemische Veränderungen (Reaktionsschwund) und/oder während der Teilentladungen können sich außerdem mechanische Spannungen entwickeln und in deren Folge Risse und Spalten im Isoliermaterial bilden. Im weiteren Verlauf können dann immer stärkere Teilentladungen auftreten, die zu wachsenden Teilentladungsbäumchen und schließlich zum unerwünschten elektrischen Durchbruch und den erwähnten gravierenden Folgeschäden führen können.

Das Auffinden von Inhomogenitäten bzw. von Folgen des Alterungsprozesses im Isolierstoff ist mit elektrischen bzw. elektromagnetischen Messmethoden empfindlich genug erst nach dem Entstehen der Zerstörungsstrukturen (Teilentladungsbäumchen) möglich. Elektrische Messungen werden unter Praxisbedingungen durch elektromagnetische Störungen beeinflusst und sind zudem technisch sehr aufwendig. Quantitative Angaben zum Grad der Zerstörung sind nur bedingt bzw. erst sehr spät möglich. Zerstörungsstrukturen müssen dazu häufig erst eine bestimmte Größe erreicht haben, d. h. der Durchschlag steht, gemessen an der veranschlagten Lebensdauer der elektrotechnischen Anlage von ca. 40 Jahren, unmittelbar bevor. Für eine effiziente Reparatur des Bauteils, bspw. innerhalb geplanter Wartungsphasen, kann es dann schon zu spät sein.

Teilentladungen können mit faseroptischen Methoden nachgewiesen werden. So beschreibt die Druckschrift US 7,668,412 B2 ein Verfahren und ein verteiltes Erfassungssystem zur Detektion von Entladungen und zum Monitoring elektrischer Leitungen. Dazu wird eine optische Faser mit einem Siliciumdioxid-Kern von weniger als 500 Mikrometer im Durchmesser und einem Mantel, in den ein lumineszierendes Material integriert ist, in die Nähe zu untersuchenden Objekte gebracht. Ein Photodetektor ist an einem zweiten Ende der optischen Faser positioniert und empfängt und misst sowohl ein direktes Emissionslicht von einem elektrischen Teilentladungsereignis und das von einem ersten reflektierenden Ende der optischen Faser reflektierte Emissionslicht. Die gemessenen Signale und ihre Ankunftszeiten werden verwendet, um die Lage und die Größe einer elektrischen Teilentladung zu bestimmen.
Außerdem beschreibt die Druckschrift DE 10 2010 061 607 A1 ein Verfahren zum Monitoring von Alterungsprozessen einer Isolierung in einer Hochspannungseinrichtung. Das Verfahren umfasst die Messung eines in der Isolierung erzeugten Lichtsignals mit einem ersten faseroptischen Sensor und die Messung einer mechanischen Größe der Isolierung mit einem zweiten faseroptischen Sensor auf Basis Fluophor-dotierter Lichtfasern, sowie das Abschätzen eines Alterungszustandes der Isolierung. Weiterhin beschreibt die DE 10 2010 061 607 A1 eine Hochspannungseinrichtung mit einer transparenten oder transluzenten Isolierung und einem faseroptischen Sensor auf Basis Fluophor-dotierter Lichtfasern und einem zweiten faseroptischen Sensor zur Detektion von Deformationen.
Die Empfindlichkeit bisheriger in Hochspannungseinrichtung während des Betriebs verwendbarer faseroptischer Systeme reicht jedoch oft nicht aus, um insbesondere Teilentladungen vorrausgehende Schädigungen der Isolierung von Hochspannungseinrichtung durch Elektronen im Energiebereich von nur einigen bis einigen zehn Elektronenvolt (eV), die zur Elektrolumineszenz führen, zuverlässig zu detektieren. Bei Lichtfasern mit einem mit Fluorophoren dotierten Kern sind die Fluorophore nicht kovalent gebunden, sondern physikalisch gelöst. Weil sie schon bei Raumtemperaturen und sogar bei tiefen Temperaturen migrieren können ist das Einsatzgebiet derartiger FOFs begrenzt. Hinzu kommt, dass ein Fachmann das Einbringen von organischen Farbstoffen in die Isolierung von Hochspannungsgarnituren kritisch betrachtet, weil sie als Verunreinigung gelten, elektrisch gut polarisierbar sind und damit Keime für das Tree-Wachstum darstellen können, das letztlich zu einem Durchschlag führen kann.

Im Hinblick auf das oben Gesagte, schlägt die vorliegende Erfindung eine Hochspannungskabelgarnitur gemäß Anspruch 1, ein Verfahren gemäß Anspruch 12 und eine Verwendung gemäß Anspruch 15 vor.

Gemäß einem Ausführungsbeispiel weist eine Hochspannungskabelgarnitur zur Aufnahme eines Hochspannungskabels mit einem zum Leiten elektrischen Stroms eingerichteten Leiter und einer den Leiter umgebenden Kabelisolierung eine Isolierung und einen Wellenleiter auf. Die Isolierung weist ein zumindest bereichsweise transparentes oder transluzentes Feldsteuerteil umfassend ein Siloxanpolymer, typischerweise ein Siloxanelastomer (elastomeren Feldsteuerteil), noch typischer ein Silikonelastomer, auf. Dabei weist das Siloxanpolymer zumindest in einem Teilgebiet des Feldsteuerteils Fluorophore, die kovalent an das Siloxanpolymer und/oder an dioe in das Siloxanpolymer eingebettete dielektrische Pigmente gekoppelt sind und/oder dielektrische Pigmente auf. Das Feldsteuerteil ist eingerichtet, die Kabelisolierung des Hochspannungskabels zumindest teilweise zu umgeben. Der Wellenleiter ist so angeordnet, dass zumindest ein durch eine Teilentladung im Feldsteuerteil verursachtes Lichtsignal vom Feldsteuerteil in den Wellenleiter einkoppeln kann.

Typischerweise ist die Hochspannungskabelgarnitur eine Kabelmuffe oder ein Kabelendverschluss.

Der Begriff "Hochspannung", wie er vorliegend verwendet wird, soll Spannungen oberhalb von etwa 1 kV umfassen, insbesondere soll der Begriff Hochspannung die in der Energieübertragung üblichen Nennspannungsbereiche der Mittelspannung von etwa 3 kV bis etwa 50 kV, der Hochspannung von etwa 50 kV bis etwa 110 kV als auch Höchstspannungen bis derzeit etwa 500 kV umfassen. Für den Fall, dass die Kabelbetriebsspannungen weiter erhöht werden, sollen auch diese Spannungsbereiche mit umfasst werden. Dabei kann es sich sowohl um Gleichspannungen als auch um Wechselspannungen handeln. Der Begriff "Hochspannungskabel", wie er vorliegend verwendet wird, soll ein Kabel beschreiben, das dazu geeignet ist, Starkstrom, d.h. elektrischen Strom von mehr als etwa einem Ampere bei Spannungen oberhalb von etwa 1 kV, zu führen. Im Folgenden werden die Begriffe Hochspannungskabel und Starkstromkabel synonym verwendet. Dementsprechend soll der Begriff der "Hochspannungsgarnitur" oder "Hochspannungskabelgarnitur" eine Vorrichtung beschreiben, die geeignet ist, Hochspannungskabel mit Hochspannungsanlagen und/oder Hochspannungskabel mit Hochspannungsfreileitungen und/oder Hochspannungskabel miteinander zu verbinden

Durch das Einbringen von Fluorophoren und/oder dielektrische Pigmenten in das Siloxanpolymer des Feldsteuerteils werden einerseits dessen elektrischen Eigenschaften (Leitfähigkeit und Dielektrizitätskonstante) nicht oder nur unwesentlich beeinflusst, so dass das Feldsteuerteil weiterhin den gewünschten Verlauf des elektrischen Feldes im Betrieb gewährleistet, andererseits kann aber der in den Wellenleiter eingekoppelte Anteil von im Feldsteuerteil entstehenden Lichtsignalen erhöht werden. Dadurch können Teilentladungen und sogar Teilentladungen vorrausgehende montagebedingte Fehler und/oder betriebsbedingte Schädigungen der Isolierung durch Elektronen im Energiebereich von nur einigen bis einigen zehn Elektronenvolt (eV), die zur Elektrolumineszenz führen, hochempfindlich und zuverlässig detektiert werden.

Die in den Wellenleiter gekoppelten Lichtsignale können zu einem optischen Detektor, z.B. einer Fotozelle oder einem Spektrometer in einer Kontrollstation weitergeleitet werden. Dies ermöglicht eine sichere Früherkennung (Online-Monitoring) von Schädigungen der Isolierung, eine Abschätzung der Lebensdauer der Anlageisolierung sowie eine langfristige Planung der Wartung und Reparatur der Anlage. Dadurch kann die Herausbildung kritischer Zerstörungsstrukturen, die einen Durchschlag einleiten, durch eine gut planbare Reparatur verhindert werden. Durch die optische Erfassung der in der Isolierung entstehenden Lichtsignale kann zudem auch der Fehlerort in der Anlage deutlich einfacher bestimmt werden.

Dementsprechend weist eine Hochspannungseinrichtung eine Hochspannungskabelgarnitur mit einem Feldsteuerteil auf Basis eines Siloxanpolymers, das zumindest in einem Teilgebiet Fluorophore und/oder dielektrische Pigmente aufweist, wobei die Fluorophore kovalent an das Siloxanpolymer und/oder an das in das Siloxanpolymer eingebettete dielektrische Pigmente gekoppelt sein können und einem Wellenleiter, der so angeordnet ist, dass ein im Feldsteuerteil entstehendes Lichtsignal vom Feldsteuerteil in den Wellenleiter einkoppeln kann, sowie einen optischen Detektor auf, der mit dem Wellenleiter der Hochspannungskabelgarnitur gekoppelt ist. Als elektrisches Versorgungsnetz kann die Hochspannungseinrichtung eine Vielzahl derartiger Hochspannungskabelgarnituren aufweisen.

Typischerweise umfasst die Hochspannungseinrichtung weiter eine mit dem optischen Detektor gekoppelte Steuer- und Auswerteeinheit, die typischerweise eine Überwachungseinrichtung für Hochspannungskabelgarnitur bildet, und / oder eine mit der Steuer- und Auswerteeinheit verbundene Lichtquelle, die innerhalb eines Gehäuses der Hochspannungskabelgarnitur, typischerweise in einem Bereich niedriger elektrischer Feldstärke während des Betriebs der mit einem oder zwei Kabeln verbundenen Hochspannungskabelgarnitur, angeordnet ist. Die Lichtquelle, z.B. eine LED, kann zur Überprüfung der Funktionsfähigkeit des vom Wellenleiter und dem optischen Detektor gebildeten Sensors für die von Schädigungsprozessen in der Isolierung verursachten Lichtsignale in dienen.

Die von den Schädigungsprozessen ausgehende und zu detektierende optische Strahlung (Lichtsignal) kann sowohl aus Elektrolumineszenz (insbesondere in Bereichen hoher elektrischer Feldstärke im Feldsteuerteil) und Photolumineszenzprozessen, jeweils in bestimmten Wellenlängenbereichen als auch aus Teilentladungsprozessen in den sich entwickelnden Entladungsbäumchen resultieren.

Der Begriff "Teilentladung", wie er vorliegend verwendet wird, soll kurzzeitige, relativ energiearme und lokal begrenzte Entladungen in der Isolierung, die nicht sofort zu einem elektrischen Durchschlag führen, aber das Material der Isolierung irreversibel schädigen, beschreiben. Der Begriff "Teilentladung" soll insbesondere den Begriff der "inneren Teilentladung", d.h. einer äußerlich nicht unbedingt sichtbaren Entladungserscheinungen in nicht gasförmigen Isoliermaterialien, insbesondere in festen Isoliermaterialien wie Polymeren, umfassen. Ausgehend von Fehlstellen, wie Hohlräumen und Fremdeinschlüssen oder Grenzflächen zu anderen Materialien, insbesondere zu hochspannungsführenden Leitern, können Teilentladungen zu im Laufe der Zeit wachsenden Teilentladungsbäumchen im Isoliermaterial führen, was schließlich zu einem Durchschlag führen kann. Teilentladungsbäumchen haben typischerweise eine Größe von mehr als etwa 1 µm (Mikrometer).

Als Maß für die Stärke einer Teilentladung kann die direkt an den Prüfanschlüssen einer elektrischen Messanordnung messbare scheinbare Ladung verwendet werden. Mit etablierten elektrischen und elektromagnetischen Messmethoden können gegenwärtig unter in der Praxis üblichen Testbedingungen Teilentladungen mit einer scheinbaren Ladung von mehr als etwa 1 pC (pico Coulomb) nachgewiesen werden. Die Industrienorm IEC 60840 Ed. 4, 2011 fordert für die Prüfung von Hochspannungskabelanlagen eine Messgenauigkeit von etwa 5 pC. Im Hochspannungsbetrieb der Hochspannungskabelgarnitur wird die Messempfindlichkeit dieser Methoden durch elektromagnetische Grundstörpegel jedoch auf einen Bereich von etwa 20 pC bis etwa 50 pC begrenzt. Der Begriff "Teilentladung", wie er vorliegend verwendet wird, soll insbesondere Entladungen in der Isolierung mit scheinbaren Ladungen, d.h. elektrisch messbaren scheinbaren Ladungen, von mehr als ca. 1 pC umfassen.

Der Wellenleiter kann im Feldsteuerteil und / oder auf einer Oberfläche des Feldsteuerteils angeordnet sein.

Typischerweise ist der Wellenleiter eine optische Faser, noch typischer eine polymere optische Faser (POF), die aus dem Siloxanpolymer des Feldsteuerteils oder einem anderen Siloxanpolymer bestehen kann. Dadurch werden Feldverzerrungen durch den Wellenleiter im Feldsteuerteil weitestgehend vermieden.

Außerdem kann die optische Faser zumindest in einem Faserabschnitt der auf dem oder im Feldsteuerteil angeordnet ist einen fluoreszenzdotierten Faserkern aufweisen. Dies ermöglicht ein besonders effizientes Einkoppeln von Licht aus dem Feldsteuerteil in die optische Faser und eine verlustarme Weiterleitung des eingekoppelten Lichts.
Der Wellenleiter kann des Weiteren in seinem Mantel und/oder in seinem Kern auch mit kovalent gebundenen Fluorophoren modifiziert sein.

Typischerweise werden die Fluorophore des Feldsteuerteils so ausgewählt, dass sie das von Schädigungsprozessen verursachte Lichtsignal in Strahlung eines Wellenlängenbereichs umwandeln können, in dem das Siloxanpolymer eine höhere Transparenz aufweist als im Wellenlängenbereich des ursprünglichen (primären) Lichtsignals. Dadurch können die Absorptionsverluste im Feldsteuerteil verringert werden und somit die Detektionsempfindlichkeit erhöht werden. Beispielsweise können die Fluorophore des Feldsteuerteils in einem Wellenlängenbereich unterhalb von 500 nm, z.B. im UV-Bereich, angeregt werden und entsprechend ihrer Stokes-Verschiebung langwelligeres Licht wieder emittieren, das vom Siloxanpolymer schwächer absorbiert wird. Als Fluorophore können bspw. Naphtalimid-Farbstoffe verwendet werden, die über entsprechende reaktive Gruppen kovalent mit dem Polymernetzwerk, typischerweise einem Silikonelastomernetzwerk, verbunden sein können.

Die Silikone besitzen neben den reaktiven Gruppen für die Kreuzvernetzung gewöhnlich auch Siloxan-Wiederholungseinheiten (-O-Si(R)(R')-O-, SiO₂R₂) aus Dimethyl- (R=R'=Methyl=CH₃), Methylphenyl- (R=Methyl=CH₃, R'=Phenyl=C₆H₅) oder Diphenylsiloxan (R=R'=Phenyl=C₆H₅) oder Kombinationen dieser Bestandteile. Fluorophore können an monomere Siloxaneinheiten, aber auch an vernetzbare oligomere Siloxane kovalent angebunden werden. Es sind jedoch auch andere Reste wie kondensierte Aromaten, fluorierte Kohlenwasserstoffe oder aliphatische Kohlenwasserstoffe möglich, an die Fluorophore kovalent gebunden werden können.

Der Massenanteil der kovalent gebundenen Fluorophore im Teilgebiet des Feldsteuerteils oder dem gesamten Feldsteuerteil bezogen auf das Siloxan beträgt in Abhängigkeit von den Absorptionsquerschnitten typischerweise zumindest 5 ppmw und kann bis etwa 500 ppmw (ppmw von englisch "parts per million by weight", entspricht 10⁶*Masse Fluorophor / Masse Siloxan) betragen. Dies ermöglicht eine hinreichend gute Umwandlung und anschließende Weiterleitung des von Schädigungsprozessen verursachten Lichtsignals im Feldsteuerteil.

Um eine besonders scharfe Trennung zwischen Absorptions-und Emissionsbanden zu erreichen, wodurch sich die Reabsorption innerhalb des dotierten Volumens des Feldsteuerteils weiter reduziert lässt, kann das Siloxanpolymer mit verschiedenen kovalent gebundenen Fluorophoren modifiziert sein, die als FRET-Paare (Förster-Resonanzenergietransfer-Paare) wirken. So kann ein Silikonpolymer mit Naphthalin und Dansyl, Naphthalimid und Diethylaminocoumarin, oder Fluoreszein und Rhodamin dotiert sein. Dabei werden jeweils zwei Moleküle des FRET-Paares vor dem kovalenten Anbinden an das Siloxan-Netzwerk durch geeignete Syntheseschritte so an ein gemeinsames (optisch und im Hinblick auf die Elektronensysteme der Fluorophormoleküle passives) Trägermolekül gebunden werden, dass ihr räumlicher Abstand dauerhaft auf einen Wert innerhalb des FRET-radius von ca. 30 bis 70 Angström begrenzt ist.

Typischerweise sind die Fluorophore kovalent an das Siloxanpolymer oder an in das Siloxanpolymer eingebettete dielektrische Partikel, die ihrerseits kovalent an das Siloxanpolymer gebunden sein können, gekoppelt. Bei den dielektrischen Partikeln kann es sich um funktionalisierte Partikel, typischerweise Nanopartikel handeln. Als dielektrische Partikel können bspw. Hydridosiloxan-oberflächenfunktionalisierte Siliziumdioxid-Partikel oder Polyorganosiloxanpartikel mit ungesättigten Funktionalitäten (z. B. Hydrido-Gruppen oder ungesättigte Kohlenwasserstoffgruppen wie Allyl-, und Vinyl-Gruppen) dienen.

Durch eine kovalente Kopplung der Fluorophore, wird die Diffusion der Fluorophore im Siloxanpolymer verhindert. Dies ermöglicht es, die Fluorophore während der prospektierten Lebensdauer von bis zu mehreren Jahrzehnten im Teilgebiet, z.B. in besonders schädigungsgefährdeten Teilgebieten oder als lichtweiterleidende Bereiche dienenden Teilgebieten, zu halten.

Das Feldsteuerteil nimmt typischerweise denjenigen Raum in der Hochspannungsgarnitur ein, in dem die Feldstärke im Hochspannungsbetrieb zu groß für die übrige Isolierung ist.

Typischerweise weist das Feldsteuerteil, das auch als Feldsteuerkörper bezeichnet wird, einen leitfähigen Deflektor zur Veränderung des elektrischen Feldverlaufs in der Hochspannungsgarnitur auf, der mit einer Kabelschirmung des Hochspannungskabels kontaktierbar ist. Das Feldsteuerteil kann insbesondere als Feldsteuerkonus mit einem integrierten leitfähigen Deflektor ausgebildet sein.

Mittels des Deflektors kann das Feldsteuerteil die Feldlinien im Hochspannungsbetrieb der Hochspannungskabelgarnitur so führen, dass die Feldstärke außerhalb des Feldsteuerteils hinreichend niedrig ist. Der leitfähige Deflektor kann durch eingelagerte Graphit- oder Rußpartikel einen hohen Absorptionskoeffizient im erwarteten Wellenlängenbereich der Elektrolumineszenzerscheinung und/oder Teilentladungserscheinung aufweisen und stellt dann einen im Wesentlichen nichttransparenten bzw. stark absorbierenden Teil des Feldsteuerteils dar.

Der Deflektor kann aus dem Siloxanpolymer des verbliebenen Teils des Feldsteuerteils oder einem anderen Siloxanpolymer bestehen. Auch das Siloxanpolymer des Deflektors kann mit kovalent gebundenen Fluorophoren modifiziert sein und/oder dielektrische Pigmente aufweisen, bspw. im Randbereich zum verbliebenen Teil des Feldsteuerteils. Dadurch kann ein Teil des Lichtsignals am Eindringen in den stärker absorbierenden Deflektor gehindert werden.

Gemäß einer Weiterbildung weist das Feldsteuerteil mehrere disjunkte oder sogar voneinander beabstandete Fluorophore und/oder dielektrische Pigmente aufweisende Teilgebiete auf. Damit lässt sich ein besonders hoher Anteil des von Schädigungsprozessen im Feldsteuerteil verursachten bzw. begleiteten Lichtsignals in den Wellenleiter einkoppeln. Beispielsweise kann das von Schädigungsprozessen im Feldsteuerteil verursachte bzw. begleitetete primäre Lichtsignal in einem ersten Teilgebiet durch deren Fluorophore in ein längerwelligeres sekundäres Lichtsignal konvertiert werden, dass von den Pigmenten eines zweiten Teilgebiets reflektiert wird und dadurch zumindest teilweise am Eindringen in den absorbierenden Deflektor gehindert, am Verlassen des Feldsteuerteils in Richtung eines nichtpolymeren weiteren Isoliergebiets gehindert und / oder zumindest in Teilen in Richtung des Wellenleiters umgelenkt wird.

Das Feldsteuerteil kann mehrere Teilgebiete mit Fluorophoren und / oder mehrere Teilgebiete mit Pigmenten, aber auch nur ein Teilgebiet mit Fluorophoren oder nur ein Teilgebiet mit Pigmenten aufweisen. Typischerweise sind Teilgebiet(e) dreidimensionale Gebiete. Wenn die Konzentration der Fluorophore bzw. Pigmente in den Teilgebiet(en) sehr hoch ist, können diese auch sehr dünn, z.B. im Vergleich zu den Dimensionen des Feldsteuerteils praktisch eine typischerweise gekrümmte Fläche (d.h. eine dünne Schicht mit großem Oberflächen/Volumen-Verhältnis) darstellen, die Nahe einer Oberfläche des Feldsteuerteils angeordnet sein kann, und / oder einen Teil der Oberfläche darstellt. Dies kann z.B. für nur Pigmente aufweisende Teilgebiet(e) interessant sein, da auch so eine gute Rückstreuung des Lichts ins das restliche Volumen des Feldsteuerteils bzw. zum Wellenleiter gewährleistet werden kann und zudem Einflüsse auf den elektrischen Feldverlauf praktisch ausgeschlossen sind, da die Felder nahe der äußeren Oberfläche des Feldsteuerteils vergleichsweise gering sind.

Typischerweise ist die Reflektivität der dielektrischen Pigmente größer als 0,8, noch typischer größer als 0,9, um möglichst viel Licht in gewünschte Richtungen zu reflektieren. Daher sind die dielektrischen Pigmente typischerweise weiß. Als dielektrische Pigmente können insbesondere Partikel aus TiO₂, ZnO, SnO, oder Al₂O₃ oder dielektrische Partikel mit Beschichtungen aus diesen Materialien dienen.

Typischerweise ist die Konzentration der dielektrischen Pigmente im Teilgebiet höher als 1 % vol., noch typischer höher als 2 % vol., und sogar noch typischer höher als 5 % vol. Dadurch kann ein hinreichend hoher Anteil des Lichtes reflektiert werden.

Typischerweise sind die Form und Anordnung des Teilgebiets bzw. der Teilgebiete und des Wellenleiters bzw. der Wellenleiter aufeinander abgestimmt, um eine besonders gute Lichtübertragung und damit hohe Messempfindlichkeit zu erreichen.

Gemäß einem Ausführungsbeispiel weist ein Verfahren zum Herstellen einer Hochspannungskabelgarnitur zur Aufnahme eines Hochspannungskabels mit einem zum Leiten elektrischen Stroms eingerichteten Leiter und einer den Leiter umgebenden Kabelisolierung die folgenden Schritte auf:
- Bilden eines zumindest bereichsweise transparenten oder transluzenten Feldsteuerteils auf Basis ein Siloxanpolymer, typischerweise auf Basis eines Silikonelastomers;
- Anordnen des Feldsteuerteils in einem Gehäuse der Hochspannungskabelgarnitur, so dass das Feldsteuerteil die Kabelisolierung des Hochspannungskabels zumindest teilweise umgeben kann; und
- Anordnen eines Wellenleiters in dem Gehäuse.

Das Verfahren wird derart ausgeführt, dass das Siloxanpolymer zumindest in einem Teilgebiet des Feldsteuerteils Fluorophore und /oder dielektrische Pigmente aufweist, und dass zumindest ein durch eine Teilentladung im Feldsteuerteil verursachtes Lichtsignal vom Feldsteuerteil in den Wellenleiter einkoppeln kann.

Typischerweise umfasst das Bilden des Feldsteuerteils das Mischen der vernetzbaren Komponenten eines oft zweikomponentigen Siloxan-Systems mit den zur Vernetzung funktionalisierten Fluorophoren, an dielektrische Partikel gebundene Fluorophoren und /oder den dielektrischen Pigmenten zur Bildung einer Mischung, das Einbringen der Mischung in die Form und das Polymerisieren der Mischung in der Form umfasst.

Da das herzustellende Feldsteuerteil typischerweise Gebiete aufweist, die frei bzw. allenfalls geringfügig mit kovalent gebundenen Fluorophoren und dielektrische Pigmenten modifiziert ist, wird in die Form auch typischerweise Siloxan ohne Fluorophore und dielektrische Pigmente eingebracht.

Je nach Anordnung und Form des bzw. der Teilgebiete kann der Prozess auch iterativ erfolgen. Dies bedeutet, dass das Feldsteuerteil mehrere Zyklen des Einbringens der Mischung oder des Siloxans und des anschließenden Polymerisierens der Mischung in der Form umfasst.

Die dielektrischen Pigmente können alternativ oder zusätzlich vor dem Einbringen der Mischung auf eine Oberfläche oder einen Oberflächenabschnitt der Form aufgebracht werden oder als Anstrich nach dem Entfernen des polymerisierten Siloxans aus der Form, z.B. durch Aufbringen einer weißen Silikonharzfarbe, d.h. einer Farbe auf Silikonharzbasis mit weißen dielektrischen Partikeln, wie TiO₂-Partikel.

Vor dem Polymerisieren (in einem Zyklus) kann ein Abschnitt des Wellenleiters in die Form eingebracht werden.

Der Wellenleiter kann aber auch nur auf einer Oberfläche des Feldsteuerteils nach dessen Formung in der Form aufgebracht werden, z.B. mit und/oder auf der Oberfläche mittels eines Silikonklebers verklebt werden. Zudem kann der aufgebrachte Wellenleiter anschließend mit einer reflektierenden Schicht auf Siloxanbasis versehen werden, z.B. durch Aufbringen einer entsprechenden Silikonharzfarbe. Dadurch können Lichtverluste weiter reduziert werden. Auch diese Schritte können vor Ort erfolgen.

Es ist sogar möglich das kovalent modifizierte Teilgebiet als äußerer Ring auf ein Steuerteil aufzuziehen und dort ggf. zu verkleben. Auch dies kann vor Ort geschehen, so dass sogar bestehende Hochspannungseinrichtung, bspw. während einer Wartung, nachgerüstet werden können.

Gemäß einem Ausführungsbeispiel wird ein Fluorophore und / oder dielektrische Pigmente aufweisendes Siloxanpolymer als Isolierung einer Hochspannungseinrichtung verwendet.

Über mindestens einen mit der Isolierung optisch gekoppelten Wellenleiter und einen mit dem mindestens einen Wellenleiter gekoppelten optischen Detektor lassen sich Schädigungen bzw. Alterungsprozesse der Isolierung hochempfindlich und zuverlässig überwachen.

Bei der Hochspannungseinrichtung handelt es sich typischerweise um eine Hochspannungskabelgarnitur, insbesondere eine Kabelmuffe oder ein Kabelendverschluss, dessen Feldsteuerteil typischerweise Teilgebiete aus dem Fluorophore und / oder dielektrische Pigmente aufweisendes Siloxanpolymer aufweist.

Das mit kovalent gebundenen Fluorophoren und / oder dielektrischen Pigmenten modifizierte Siloxanpolymer kann aber auch als Isolierung in anderen Hochspannungseinrichtungen wie Spannungswandlern (Trafos) und Schaltanlagen verwendet werden.

Gemäß einem Ausführungsbeispiel umfasst eine Hochspannungseinrichtung eine zumindest bereichsweise transparente oder transluzente Isolierung auf Basis eines Siloxanpolymers, wobei das Siloxanpolymer zumindest in einem Teilgebiet der Isolierung Fluorophore und/oder dielektrische Pigmente aufweist, und einen Wellenleiter, der so angeordnet ist, dass zumindest ein durch eine Teilentladung in der Isolierung verursachtes Lichtsignal von der Isolierung in den Wellenleiter einkoppeln kann.

Weitere vorteilhafte Ausgestaltungen, Einzelheiten, Aspekte und Merkmale der vorliegenden Erfindung ergeben sich aus den Unteransprüchen, der Beschreibung sowie den beigefügten Zeichnungen. Darin zeigt:
**Fig. 1** einen schematischen Querschnitt einer Hochspannungsgarnitur gemäß einem Ausführungsbeispiel;
**Fig. 2** einen schematischen Querschnitt einer Hochspannungsgarnitur gemäß einem Ausführungsbeispiel;
**Fig. 3** einen schematischen Querschnitt einer Hochspannungsgarnitur gemäß noch einem Ausführungsbeispiel;
**Fig. 4** einen schematischen Querschnitt einer Hochspannungsgarnitur gemäß einem Ausführungsbeispiel;
**Fig. 5** einen schematischen Querschnitt einer Hochspannungsgarnitur gemäß einem Ausführungsbeispiel;
**Fig. 6** einen schematischen Querschnitt einer Hochspannungsgarnitur gemäß einem Ausführungsbeispiel; und
**Fig. 7** einen schematischen Querschnitt einer Hochspannungsgarnitur gemäß noch einem Ausführungsbeispiel.

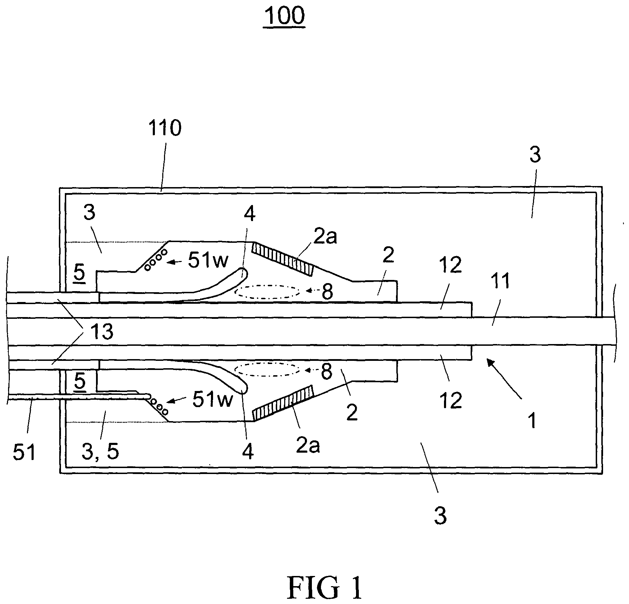

Fig. 1 zeigt eine Hochspannungsgarnitur 100 zur Aufnahme eines Hochspannungskabels 1 gemäß einem Ausführungsbeispiel in einer schematischen zentralen Querschnittsansicht entlang der Zylinderachse des Hochspannungskabels 1. Das rotationssymmetrische Hochspannungskabel 1 enthält im Innern einen Leiter 11 zum Leiten von Starkstrom, bspw. einen Aluminium- oder Kupferleiter, der von einer Kabelisolierung 12, typischerweise einer VPE-Isolierung (vernetztes Polyethylen), und einer äußeren Kabelschirmung 13, z.B. einer äußeren Leitschicht oder einem halbleitenden äußeren Kabelschirm, umgeben ist. Weiterhin kann das Hochspannungskabel 1 zusätzlich Polsterschichten und einen Kupferschirm und einen äußeren Mantel zum Schutz gegenüber Umwelteinflüssen aufweisen. Dabei kann es sich um einen Polyethylen-Mantel oder einen Mantel aus einem anderen halogenfreien Material handeln. Diese Komponenten sind in Fig. 1 und den folgenden Figuren aus Gründen der Übersichtlichkeit nicht dargestellt. Außerdem kann das Hochspannungskabel 1 eine innere Leitschicht zwischen dem Leiter 11 und der VPE-Isolierung aufweisen. Diese innere Leitschicht ist ebenfalls nicht dargestellt.

Die in Fig. 1 dargestellte Hochspannungsgarnitur 100 stellt einen Kabelendverschluss 100 dar, wie er z.B. bei Freileitungen verwendet wird. Der Kabelendverschluss 100 hat ein Gehäuse 110, z.B. ein Keramikgehäuse, das die inneren Teile der Hochspannungsgarnitur 100 gegenüber der Umgebung abschließt. Das Gehäuse 110 umschließt (abgesehen von Öffnungen z.B. für das Hochspannungskabels 1) typischerweise einen im Querschnitt axialsymmetrischen, z.B. zylindersymmetrischen Innenraum. Im Innern (Innenraum) des Gehäuses 110 ist ein Isoliergebiet 3 angeordnet. Das Isoliergebiet 3 kann z.B. durch einen mit Öl oder Gas gefüllten weitgehend transparenten Isolierraum gebildet werden.

An dem in den Kabelendverschluss 100 eingeführten Hochspannungskabel 1 sind die äußeren Schichten (Kabelmantel, Polsterschichten und metallischer Schirm) entfernt, die typischerweise halbleitende äußere Kabelschirmung 13 bis in den Bereich des Feldsteuerteils weitergeführt und danach durch den Endverschluss hindurch bis zur Kopfarmatur nur noch die Kabelisolierung 12 mit dem Leiter 11 axial weitergeführt. Nur der Leiter 11 wird vollständig durch den Kabelendverschluss 100 geführt, um im rechten Bereich von Figur 1 nach Verlassen des Kabelendverschlusses 100 an die Freileitung angeschlossen zu werden. Im Innern des Kabelendverschlusses 100 ist der Leiter 11 nur im Bereich der entfernten Kabelisolierung vom Isoliergebiet 2 direkt umgeben. Zur Aufnahme des Hochspannungskabels 1 ist in den Innenraum des Gehäuses 110 ein rotationssymmetrisches elektrisch isolierendes Feldsteuerteil 2 eingesetzt, das denjenigen Teil des Innenraums einnimmt, in dem die elektrische Feldstärke zu groß für die Isoliermaterialien im Isoliergebiet 3 wäre. Das Feldsteuerteil 2 verfügt über einen inneren Hohlzylinder, in den das Hochspannungskabel 1 eingeschoben werden kann. Beispielsweise kann das Feldsteuerteil 2 als Feldsteuerkonus ausgeführt sein.

Typischerweise ist das Feldsteuerteil 2 ein elastomeres Feldsteuerteil, das zumindest bereichsweise aus einem transparenten oder transluzenten Elastomerkörper besteht, z.B. aus einem Silikonelastomerkörper mit hinreichend hoher Transparenz bei einer oder mehreren Wellenlängen aus einem Bereich von etwa 300 nm bis etwa 900 nm. Der innere Hohlzylinder ist typischerweise so dimensioniert, dass zwischen der Kabelisolierung 12 des eingeschobenen Kabels 1 und dem Feldsteuerteil 2 eine Presspassung vorliegt und das Feldsteuerteil 2 somit einen Stresskonus bildet. Das nichtpolymere Isoliergebiet 3 und das Feldsteuerteil 2 bilden zusammen die Isolierung 2, 3 des Kabelendverschlusses 100.

Das Feldsteuerteil 2 und/oder das Hochspannungskabel 1 können zusätzlich, beispielsweise über Federn, am Gehäuse 110 oder in einem sich auf Erdpotential befindenden (zumindest nahezu feldfreien) kabelnahen Bereich 5 des Isoliergebiets 3 fixiert werden, z.B. wenn das Isoliergebiets 3 durch einen Feststoffisolierkörper gebildet ist. Eine derartige Fixierung von Feldsteuerteil 2 und/oder Hochspannungskabel 1 wird typischerweise bei einem Aufbau des Kabelendverschlusses 100 in Komponentenbauweise verwendet. Die Isolierung 2, 3 umfasst unabhängig von der verwendeten Bauweise ein Feldsteuerteil 2 zur Aufnahme des Kabels 1 mit teilweise entfernter Kabelisolierung 12 und zur geeigneten Führung der Feldlinien im Hochspannungsbetrieb. Eine nicht nichtdargestellte Kabelmuffe weist dagegen zwei Feldsteuerteile zur Aufnahme jeweils eines von zwei zu verbindenden Kabeln mit teilweise entfernter Kabelisolierung und zur geeigneten Führung der Feldlinien im Hochspannungsbetrieb der Hochspannungskabelgarnitur auf.

Für den Abbau des elektrischen Feldes wird typischerweise ein elastomeres Feldsteuerteil 2 verwendet, in das ein geeignet geformter leitfähiger Deflektor 4 integriert ist. Der leitfähige Deflektor 4 ist in elektrischem Kontakt mit der Kabelschirmung 13. Typischerweise besteht der leitfähige Deflektor 4 ebenfalls aus einem Silikoneleastomer, der jedoch durch Dotierung, z.B. mit Kohlenstoff, über eine geeignete elektrische Leitfähigkeit verfügt.

Aufgrund von Materialinhomogenitäten oder Fehlern gibt es während des Betriebs typischerweise Bereiche 8 erhöhter Feldstärke im Feldsteuerteil 2. Die Wahrscheinlichkeit für das Auftreten von Schädigungen bzw. das Einsetzen von Teilentladungen und damit das Auftreten von Lichtsignalen ist in den Bereichen 8 mit erhöhter Feldstärke erhöht.

In dem in Fig. 1 dargestellten exemplarischen Ausführungsbeispiel führt ein Wellenleiter 51 in den Innenraum der Hochspannungsgarnitur 100 bis in das Feldsteuerteil 2, worin er mehre Windungen 51w nahe der Oberfläche des Feldsteuerteils 2 bildet. Der Wellenleiter 51 ist somit teilweise in das Feldsteuerteil 2 eingebettet. Da der Wellenleiter 51 in einem Gebiet niedriger Feldstärken während des Betriebs angeordnet ist (vom Bereich 8 durch den Deflektor abgeschirmt), haben etwaige moderate Unterschiede der effektive Dielektrizitätskonstanten des Wellenleiters 51 von der Dielektrizitätskonstanten des Materials des Feldsteuerteils 2 (Siloxan) nur einen geringen Einfluss auf den Feldverlauf im Hochspannungsbetrieb.

Aufgrund der spulenförmigen oder spiralhelixförmigen Windungen 51W kann die Wahrscheinlichkeit für das Einkoppeln eines einen hochspannungsfeldinduzierten und ladungsträgervermittelten Veränderungsprozesses (Schädigungsprozess) im Feldsteuerteil 2 begleitetenden primären Lichtsignals in den Wellenleiter 51 erhöht werden. Damit kann auch die Detektionswahrscheinlichkeit für den Schädigungsprozess mittels eines mit dem Wellenleiter gekoppelten optischen Detektors erhöht werden.

Die Detektionswahrscheinlichkeit für den Schädigungsprozess kann auch durch das im exemplarischen Ausführungsbeispiel hohlkegelstumpfförmige Teilgebiet 2a des Feldsteuerteils 2 erhöht werden, da Silikonelastomer des Feldsteuerteils 2 im Teilgebiet 2a mit kovalent gebundenen Fluorophoren modifiziert ist, die ein am wahrscheinlichsten im Bereich 8 entstehendes primäres Lichtsignal in ein längerwelligeres sekundäres Lichtsignal konvertieren, das weniger stark absorbiert wird. Außerdem führt auch die ungerichtete Emission der Photonen von den Fluorophoren zu einer Verringerung des Anteils des Lichtes, dass das Feldsteuerteil 2 in das Isoliergebiet 3 verlässt.

Der Wellenleiter 51 ist typischerweise eine fluoreszenzoptische Lichtleitfaser (FOF von engl. "fluorescent optical fiber"), noch typischer eine polymere fluoreszenzoptische Lichtleitfaser (engl. "fluorescent polymer optical fiber") mit dotiertem Kern. Typischerweise ist das Absorptionswellenspektrum des Fluorophors auf das erwartete Spektrum der Lichtsignale im Feldsteuerteil 2 abgestimmt. Damit kann ein extrem empfindlicher Sensor für die Lichtsignale bereitgestellt werden. Insbesondere kann vorgesehen sein, dass der Kern der FOF sowohl Fluorophore mit einem auf das primäre Lichtsignal abgestimmten Absorptionsspektrum als auch Fluorophore mit einem auf ein Emissionsspektrum der Fluorophore des Teilgebiets 2a abgestimmten Absorptionsspektrum aufweist (mehrfach dotierter Kern der FOF).

Beispielsweise können die Fluorophore des Teilgebiets 2a Licht aus einem Teilbereich des Wellenlängenbereichs von 280 nm bis 500 nm, typischer von 315 nm bis 500 nm und noch typischer von 350 nm bis 500 nm absorbieren und längerwelligeres (sekundäres) Licht im Wellenlängenbereich oberhalb von 500 nm, z.B. im Bereich von 500 nm bis 800 nm emittieren, typischerweise in einen Teilbereich davon, in dem die Fluorophore des Kerns der FOF absorbieren. Das Emissionsspektrum der Fluorophore des Teilgebiets 2a hat dabei typischerweise einen starken Überlapp mit dem Absorptionsspektrum der Fluorophore des Kerns der FOF. Es ist auch möglich, mehrere Fluorophore zu nutzen, und ein Energiegefälle zu erzeugen. Weiterhin ist die Verwendung von geeignet geometrisch fixierten Fluoreszenzfarbstoffpaaren möglich, die einen strahlungslosen und damit verlustfreien Energietransfer ermöglichen (FRET Paare).

Falls die effektive Dielektrizitätskonstante der Lichtleitfaser 51 von der des Feldsteuerteils 2 abweicht, kann es zu einer Veränderung der elektrischen Feldverteilung in der Isolierung kommen. Dann kann zusätzlich vorgesehen sein, dass die Form und/oder Leitfähigkeit des Feldsteuerteils 2, insbesondere des Deflektors so modifiziert wird, dass die Veränderung des elektrischen Feldes durch die Lichtleitfaser 51 kompensiert wird. Eine Veränderung der elektrischen Feldverteilung kann jedoch auch zumindest dann weitgehend vermieden werden, wenn die Lichtleitfaser 51 ebenfalls auf einem Siloxan basiert.

Die fluoreszenzoptische Lichtleitfaser 51 bildet typischerweise zusammen mit einem nichtdargestellten optischen Detektor einen sogenannten "FOF-Sensor", d.h. dass der Detektor auf ein Emissionswellenspektrum des Fluorophors (bzw. der Fluorophor) des dotierten Kerns abgestimmt ist. Sowohl Mantel als auch Kern der Lichtleifaser können auch mit kovalent gebundenen Fluorophoren modifiziert sein.

Zumindest ein Ende der fluoreszenzoptischen Lichtleitfaser 51 ist mit dem optischen Detektor verbunden (optisch gekoppelt). Es können aber auch beide Enden der fluoreszenzoptischen Lichtleitfaser 51 mit dem optischen Detektor verbunden sein. Dadurch kann eine besonders hohe Messempfindlichkeit erreicht werden. Bei dem optischen Detektor handelt es sich typischerweise um einen opto-elektrischen Wandler, z.B. um eine Photodiode, bspw. eine Avalanche-Photodiode, oder auch um einen Photomultiplier oder sogar um ein Spektrometer.

Der optische Detektor und eine mit ihm verbundene Auswerteeinheit (ebenfalls nicht dargestellt) befinden sich typischerweise in einem feldfreien Raum 5 oder außerhalb des Endverschlussgehäuses 110. Damit können Detektor und Auswerteeinheit weitgehend vor elektromagnetischen Störungen des Hochspannungsfeldes geschützt werden. Die Auswerteeinheit kann sogar eine Steuer- und Auswerteeinheit sein.

Die fluoreszenzoptische Lichtleitfaser 51 kann direkt zur Auswerteeinheit geführt werden. Es ist aber auch möglich, die fluoreszenzoptische Lichtleitfaser 51 über eine Transportlichtleitfaser mit geringerer Dämpfung mit der Auswerteeinheit zu verbinden.

Außerdem ist es auch möglich, nicht nur eine fluoreszenzoptische Lichtleitfaser 51 mit einem abgestimmten Absorptionswellenlängenbereich, sondern mehrere mit verschiedenen Absorptionswellenlängenbereichen im Feldsteuerteil einzubetten. Dadurch kann ein breiterer Ausschnitt aus dem Emissionsspektrum von Teilentladungen und/oder Elektrolumineszenz hochempfindlich erfasst werden. Jede dieser fluoreszenzoptischen Lichtleitfasern kann über eine eigene Transportlichtleitfaser mit einem individuellen Detektor, z.B. einer auf den jeweiligen Fluorophor angepassten individuellen Fotodiode verbunden werden. Die Signale der individuellen Fotodioden können dann bspw. einfach addiert werden, um ein integrales Maß für die Lichtleistung zu ermitteln.

Der leitfähige Deflektor 4 kann auf Grund seiner Dotierung intransparent sein. In diesem Fall, schattet der Deflektor, wie aus Fig. 1 ersichtlich, die fluoreszenzoptische Lichtleitfaser 51 optisch zumindest teilweise vom Bereich 8 mit erhöhter Feldstärke ab. Auf Grund des fluoreszenzdotierten Teilgebiets 2a können vom Bereich 8 ausgehende primäre Lichtsignale dennoch über sekundäre Lichtsignale detektiert werden.

Alternativ dazu kann das Teilgebiets 2a auch anstelle der Fluorophore mit Pigmenten dotiert sein, die primären Lichtsignale gut reflektieren, z.B. Titanoxid-Partikeln. Auch damit lässt sich der Abschattungseffekt eines intransparenten bzw. stark absorbierenden Deflektors 4 zumindest teilweise kompensieren.

Es kann sogar vorgesehen sein, das Teilgebiets 2a einen fluoreszenzdotierten inneren Teil (inneren Ring, auf Grund der Achssymmetrie ist das Teilgebiet typischerweise im Wesentlichen ringförmig) und einen pigmentdotierten äußeren Teil (äußeren Ring) aufweist. Mit dieser Anordnung kann besonders viel Lichtleistung aus dem Feldsteuerteil in die Lichtleitfaser 51 eingekoppelt werden.

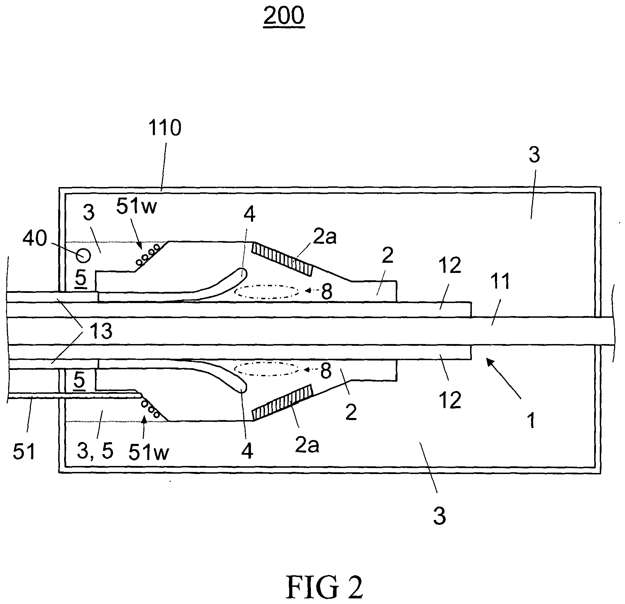

Fig. 2 zeigt eine Hochspannungsgarnitur 200 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 200 ist ähnlich zur mit Bezug zur Fig. 1 erläuterten Hochspannungsgarnitur 100 und stellt ebenfalls einen Kabelendverschluss dar. Die Lichtleitfaser 51 des Kabelendverschlusses 200 ist jedoch nicht eingebettet in das Feldsteuerteil 2, sondern auf seiner äußeren Oberfläche angeordnet, z.B. mit ihr verklebt. Auch mit dieser Anordnung können hochspannungsfeldverursachten Alterungsprozesse hochempfindlich detektiert werden.

Außerdem ist im feldfreien Raum 5 eine Lichtquelle 40, z.B. eine LED, angeordnet, die mit der Steuer- und Auswerteeinheit verbunden ist und von dieser zur Überprüfung und / oder Kalibrierung des faseroptischen Sensors verwendet werden kann.

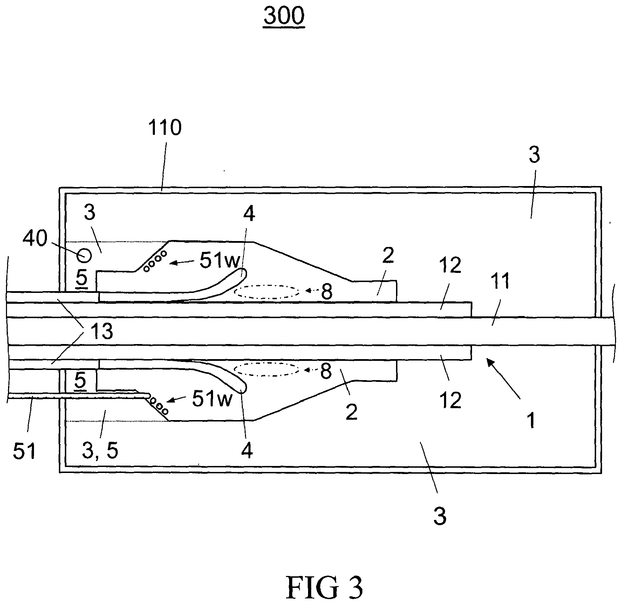

Fig. 3 zeigt eine Hochspannungsgarnitur 300 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 300 ist ähnlich zur mit Bezug zur Fig. 1 Hochspannungsgarnitur 100 und stellt ebenfalls einen Kabelendverschluss dar. Das Feldsteuerteil 2 des Kabelendverschlusses 200 besteht jedoch mit Ausnahme des Deflektors 4 aus einem mit Fluorophoren dotierten Siloxanelastomer, z.B. aus einem mit Fluorophoren dotierten Silikonelastomer. Das Feldsteuerteil 2 des Kabelendverschlusses 200 kann relativ einfach hergestellt werden, da abgesehen vom Deflektor 4 nur ein mit Fluorophoren versetzte Siloxan benötigt wird.

Außerdem ist in diesem exemplarischen Ausführungsbeispiel auch der Bereich 8 mit erhöhter Feldstärke mit Fluorophoren dotiert. Daher können die im Bereich 8 der höchsten Gefährdung für feldinduzierte Alterungsprozesse auftretenden primären Lichtsignale effizient in längerwelligere sekundäre Lichtsignale konvertiert werden und auf Grund der geringeren Absoptionsverluste der sekundären Lichtsignale die Messempfindlichkeit erhöht werden.

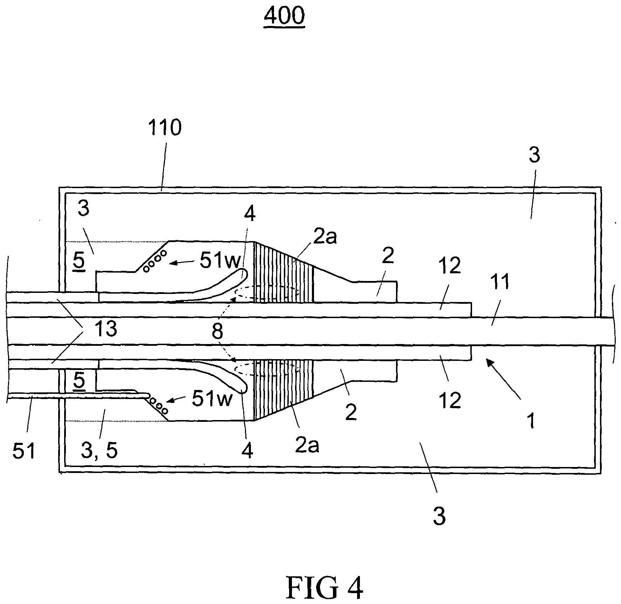

Dies gilt auch weitgehend für den in Fig. 4 in einer schematischen zentralen Querschnittsansicht entlang der Zylinderachse des Hochspannungskabels 1 dargestellten Kabelendverschluss 400, dessen Feldsteuerteil 2 ein hohlkegelförmiges, mit Fluorophoren dotiertes Teilgebiet 2a hat, das den Bereich 8 der höchsten Gefährdung für feldinduzierte Alterungsprozesse größtenteils beinhaltet.

Das den Bereich 8 teilweise oder ganz Teilgebiet 2a kann alternativ zu der in Fig. 4 dargestellten Geometrie hohlzylinderförmig ausgebildet sein und sich z.B. bis zur oder bis nahe zur Kabelisolierung 12 erstrecken.

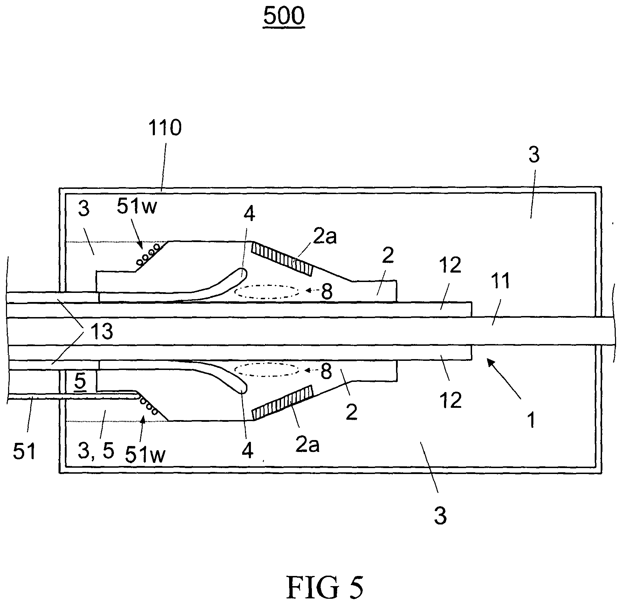

Fig. 5 zeigt eine Hochspannungsgarnitur 500 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 500 ist ähnlich zur mit Bezug zur Fig. 1 Hochspannungsgarnitur 100 und stellt ebenfalls einen Kabelendverschluss dar. Das Teilgebiet 2a des Feldsteuerteils 2 des Kabelendverschlusses 500 ist jedoch nicht mit Fluorophoren sondern mit dielektrischen Pigmenten dotiert. Durch die Reflektion der insbesondere vom Bereich 8 ausgehenden primären Lichtsignale an den dielektrischen Pigmenten des Teilgebiets 2a kann der Anteil des primären Lichtsignals, der in die Lichtleitfaser 51 einkoppelt erhöht werden. In dieser Ausführungsform bildet das Teilgebiet 2a eine reflektierende Schicht.

Im exemplarischen Ausführungsbeispiel von Fig. 5 ist die Lichtleitfaser 51 nur an der Oberfläche des Feldsteuerteils 2 angeordnet. Dies ermöglicht es, die Lichtleitfaser 51 vor Ort zu installieren bzw. nachzurüsten. Die Lichtleitfaser 51 des Kabelendverschlusses 500 kann aber auch wie oben mit Bezug zu Fig. 1 erläutert teilweise in das Feldsteuerteil 2 eingebettet sein. Auf Grund der definierten Herstellungsbedingungen, ist dann mit einer geringeren Schwankung der Sensitivität für die Messung feldinduzierter Alterungsprozesse zu rechnen. Wenn die Lichtleitfaser 51 teilweise in das Feldsteuerteil 2 eingebettet ist, können Lichtverluste zudem durch ein (weiteres) als reflektierende Schicht wirkendes Teilgebiet des Feldsteuerteils 2 mit dielektrischen Pigmenten, das vom Bereich 8 aus gesehen hinter den Windungen 51w angeordnet ist, weiter reduziert werden. Diese Aussagen gelten analog auch für die Ausführungsbeispiele der Figuren 3, 4.

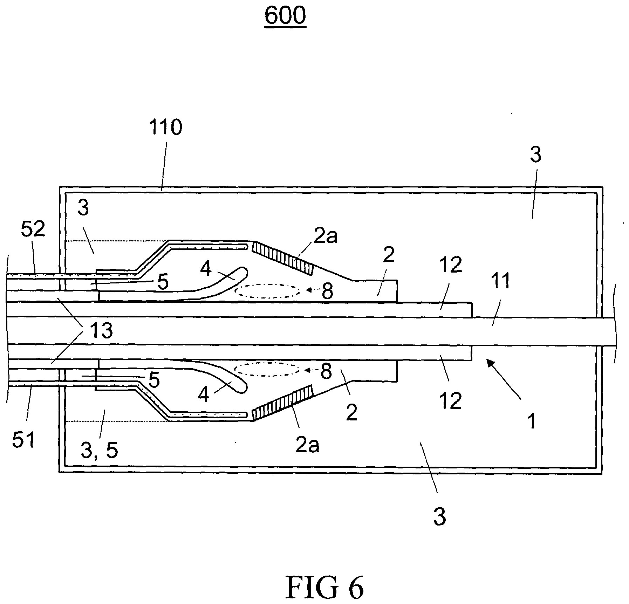

Fig. 6 zeigt eine Hochspannungsgarnitur 600 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 600 ist ähnlich zur Hochspannungsgarnitur 100 und stellt ebenfalls einen Kabelendverschluss dar. In das Feldsteuerteil 2 des Kabelendverschlusses 600 sind jedoch zwei Lichtleitfasern 51, 52 (oder sogar mehr als zwei Lichtleitfasern) eingebettet und umfänglich angeordnet. Außerdem sind die Lichtleitfasern 51, 52 bis an das mit Fluorophoren dotierte Teilgebiet 2a, oder zumindest bis dicht an das Teilgebiet 2a geführt. Mit dieser Anordnung können hochspannungsfeldverursachten Alterungsprozesse besonders empfindlich über die damit verbundenen Lichtsignale detektiert werden.

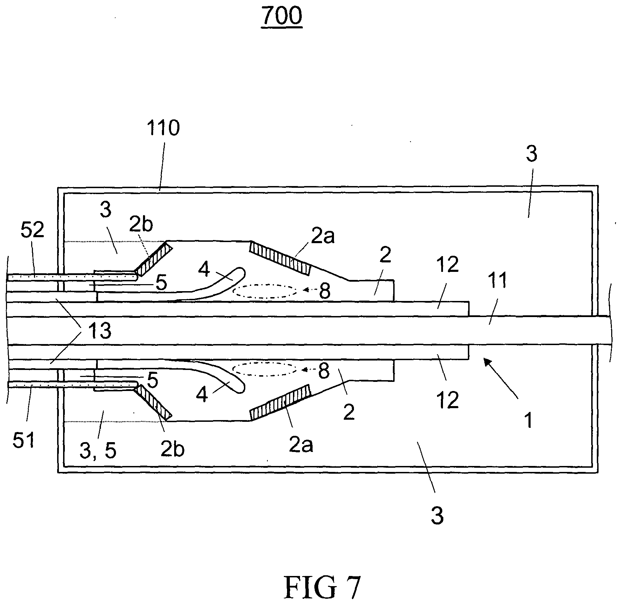

Fig. 7 zeigt eine Hochspannungsgarnitur 700 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 700 ist ähnlich zur mit Bezug zur Fig. 6 erläuterten Hochspannungsgarnitur 600 und stellt ebenfalls einen Kabelendverschluss dar. Die Lichtleitfasern 51, 52 des Kabelendverschlusses 700 führen jedoch nicht bis zum Teilgebiet 2a, sondern nur bis zu einem weiteren Teilgebiet 2b, das ebenfalls mit Fluorophoren ist.

Während die Fluorophore des Teilgebiets 2a typischerweise Licht aus einem Teilbereich des Wellenlängenbereichs von 280 nm bis 500 nm, noch typischer von 315 nm bis 500 nm und sogar noch typischer von 350 nm bis 500 nm absorbieren und längerwelligeres (sekundäres) Licht im Wellenlängenbereich oberhalb von 500 nm, z.B. im Bereich von 500 nm bis 800 nm emittieren, typischerweise in einen Teilbereich davon, in dem die Fluorophore des weiteren Teilgebiets 2a und ggf. auch die Fluorophore des Kerns der Lichtleitfasern 51, 52 gut absorbieren. Das Emissionsspektrum der Fluorophore des Teilgebiets 2a hat dabei typischerweise einen starken Überlapp zumindest mit dem Absorptionsspektrum der Fluorophore des Teilgebiets 2b.

Alternativ dazu kann das Teilgebiet 2a des Kabelendverschlusses 700 auch als reflektierendes Teilgebiet, d.h. als mit dielektrischen Pigmenten dotiertes Teilgebiet, ausgebildet sein.

Gemäß einem weiteren nichtdargestellten Ausführungsbeispiel werden typischerweise mehrere fluoreszenzoptische Lichtleitfasern, bspw. vier Lichtfasern, jeweils als Halbschleife ausgeführt und mit einer als "Schleifring" fungierenden Sammelfaser, die mit einem weiteren Fluorophor dotiert ist, in das Feldsteuerteil eingebettet. Dabei kann vorgesehen sein, dass die Sammelfaser auf der den Halbschleifen abgewandten Seite mit einer weißen, reflektierenden Schicht; z.B. einer TiO₂-Partikel oder ZnO-Partikel enthaltenden Schicht, beschichtet ist. Dadurch kann die Lichteinkoppeleffizienz weiter erhöht werden.

Die vorliegend beschriebenen Hochspannungseinrichtungen haben eine zumindest bereichsweise transparente oder transluzente Isolierung auf Basis eines Siloxanpolymers, typischerweise auf Basis eines Silikonelastomers, wobei das Siloxanpolymer zumindest in einem Teilgebiet der Isolierung Fluorophore und/oder dielektrische Pigmente aufweist, und einen Wellenleiter, typischerweise eine optische Faser mit einen fluoreszenzdotierten Faserkern, der so angeordnet ist, dass ein in der Isolierung entstehendes Lichtsignal von der Isolierung in den Wellenleiter einkoppeln kann. Das in der Isolierung entstehendes Lichtsignal kann bspw. ein Teilentladungsblitz sein oder von einem der Teilentladung vorrausgehenden elektrisch induzierten Veränderungsprozess der Isolierung verursacht werden, z.B. ein Elektrolumineszenzsignal, sein.

Im Vergleich zu außerhalb der Hochspannungseinrichtung (-garnitur) angeordneten elektromagnetischen oder piezoelektrischen Sensoren oder Messaufbauten ermöglicht die faseroptische Messung eine einfachere und/oder empfindlichere und/oder frühere Detektion von hochspannungsfeldverursachten Alterungsprozessen in der Isolierung. In Kombination mit einem oder mehreren Teilgebieten der Isolierung, die jeweils mit kovalent gebundenen Fluorophoren und/oder dielektrischen Pigmenten modifiziert sind, lässt sich die Detektionsempfindlichkeit von hochspannungsfeldverursachten Alterungsprozessen in der Isolierung deutlich weiter erhöhen.

## Patentansprüche

1. Hochspannungskabelgarnitur (100-700) zur Aufnahme eines Hochspannungskabels (1, 22) mit einem zum Leiten elektrischen Stroms eingerichteten Leiter (11, 112) und einer den Leiter (11, 112) umgebenden Kabelisolierung (12, 122), umfassend:
- eine Isolierung (2-5) umfassend ein zumindest bereichsweise transparentes oder transluzentes Feldsteuerteil (2, 4) umfassend ein Siloxanpolymer, wobei das Feldsteuerteil (2, 4) eingerichtet ist, die Kabelisolierung (12, 122) des Hochspannungskabels (1, 22) zumindest teilweise zu umgeben, und wobei das Siloxanpolymer zumindest in einem Teilgebiet (2a, 2b) des Feldsteuerteils Fluorophore aufweist, wobei die Fluorophore kovalent an das Siloxanpolymer und/oder an in das Siloxanpolymer eingebettete dielektrische Pigmente gekoppelt sind; und
- einen Teil der Isolierung (2-5) bildenden Wellenleiter (51, 51W, 52), der so angeordnet ist, dass ein durch eine Teilentladung im Feldsteuerteil (2, 4) verursachtes Lichtsignal vom Feldsteuerteil (2, 4) in den Wellenleiter (50) einkoppeln kann.

2. Hochspannungskabelgarnitur (100) nach Anspruch 1, wobei der Wellenleiter (51, 51W) zumindest teilweise im Feldsteuerteil (2, 4) und / oder zumindest teilweise an einer Oberfläche des Feldsteuerteils (2, 4) angeordnet ist.

3. Hochspannungskabelgarnitur (100) nach einem der vorangegangenen Ansprüche, wobei der Wellenleiter (51, 51w, 52) fluoreszenzdotiert oder mit Fluorophoren kovalent im Kern und/oder Mantel modifiziert ist.

4. Hochspannungskabelgarnitur (100) nach einem der vorangegangenen Ansprüche, wobei der Wellenleiter (51, 51w, 52) das Siloxanpolymer oder ein weiteres Siloxanpolymer umfasst.

5. Hochspannungskabelgarnitur (100) nach einem der vorangegangenen Ansprüche, wobei das Feldsteuerteil einen leitfähigen Deflektor (4) aufweist, der mit einer Kabelschirmung (13) des Hochspannungskabels (1, 22) kontaktierbar ist, und/oder wobei der Deflektor das Siloxanpolymer oder ein weiteres Siloxanpolymer umfasst.

6. Hochspannungskabelgarnitur (100) nach einem der vorangegangenen Ansprüche, wobei das Siloxanpolymer verschiedene Fluorophore aufweist, und /oder wobei die Fluorophore des Feldsteuerteils (2, 4) so ausgewählt sind, dass sie einen Anteil des Lichtsignal in Strahlung in einem Wellenlängenbereich umwandeln können, in dem das Siloxanpolymer eine höhere Transparenz aufweist als in einem Wellenlängenbereich des Anteils des Lichtsignal, und /oder wobei die Fluorophore des Feldsteuerteils (2, 4) in einem Wellenlängenbereich unterhalb von 500 nm angeregt werden können, und / oder wobei die Fluorophore des Feldsteuerteils (2, 4) so ausgewählt und angeordnet sind, dass Paare unterschiedlicher Fluorophore im Feldsteuerteil (2, 4) als FRET-Paar wirken können.

7. Hochspannungskabelgarnitur (100) nach einem der vorangegangenen Ansprüche, wobei eine Reflektivität der dielektrischen Pigmente größer als 0,8 ist.

8. Hochspannungskabelgarnitur (100) nach einem der vorangegangenen Ansprüche, wobei ein Massenanteil der Fluorophore höher als 5 ppmw ist, und/oder eine Konzentration der dielektrischen Pigmente höher als 1% vol ist.

9. Hochspannungskabelgarnitur (100) nach einem der vorangegangenen Ansprüche, wobei die Hochspannungskabelgarnitur eine Kabelmuffe oder ein Kabelendverschluss ist.

10. Hochspannungseinrichtung umfassend eine Hochspannungskabelgarnitur (100-700) nach einem der vorangegangenen Ansprüche und einen optischen Detektor, der mit dem Wellenleiter (51, 52) gekoppelt ist.

11. Hochspannungseinrichtung nach Anspruch 101, weiter umfassend eine mit dem optischen Detektor gekoppelte Steuer- und Auswerteeinheit, und / oder eine mit der Steuer- und Auswerteeinheit verbundene Lichtquelle (40), die innerhalb eines Gehäuses (110) der Hochspannungskabelgarnitur (100) angeordnet ist.

12. Verfahren zum Herstellen einer Hochspannungskabelgarnitur (100-600) zur Aufnahme eines Hochspannungskabels (1, 22) mit einem zum Leiten elektrischen Stroms eingerichteten Leiter (11, 112) und einer den Leiter (11, 112) umgebenden Kabelisolierung (12, 122), umfassend:
- Bilden eines zumindest bereichsweise transparenten oder transluzenten Feldsteuerteils (2, 4) umfassend ein Siloxanpolymer;
- Anordnen des Feldsteuerteils (2, 4) in einem Gehäuse (110) der Hochspannungskabelgarnitur (100), so dass das Feldsteuerteil (2, 4) die Kabelisolierung (12, 122) des Hochspannungskabels (1, 22) zumindest teilweise umgeben kann; und
- Anordnen eines Wellenleiters (51, 52) in dem Gehäuse (110), derart, dass das Siloxanpolymer zumindest in einem Teilgebiet (2a, 2b) des Feldsteuerteils Fluorophore, die kovalent an das Siloxanpolymer und / oder an in das Siloxanpolymer eingebettete dielektrische Partikel gekoppelt sind, und / oder dielektrische Pigmente aufweist, und dass ein durch eine Teilentladung im Feldsteuerteil (2, 4) verursachtes Lichtsignal vom Feldsteuerteil (42, 4) in den Wellenleiter (51, 52) einkoppeln kann.

13. Verfahren nach Anspruch 12, wobei das Bilden des Feldsteuerteils (2, 4) das Mischen eines Siloxansystems mit den Fluorophoren und /oder dielektrische Pigmenten zur Bildung einer Mischung; das Einbringen der Mischung und / oder eines Abschnitts des Wellenleiters in eine Form; und / oder das Polymerisieren der Mischung in der Form umfasst.

14. Verfahren nach Anspruch 12 oder 13, umfassend das Anordnen des Wellenleiters (51, 51W, 52) und/oder der dielektrische Pigmente an einer Oberfläche des Feldsteuerteils (2, 4).

15. Verwendung eines Fluorophore und/oder dielektrische Pigmente aufweisenden Siloxanpolymers als Isolierung (2-5) einer Hochspannungseinrichtung (100-700), wobei die Fluorophore kovalent an das Siloxanpolymer und / oder an in das Siloxanpolymer eingebettete dielektrische Partikel gekoppelt sind.

16. Verwendung nach Anspruch 15, wobei die Isolierung (2-5) ein Feldsteuerteil (2, 4) aufweist.

## Claims

1. A high-voltage cable accessory (100-700) for the accommodation of a high-voltage cable (1, 22) with a conductor (11, 112) adapted to conduct electrical current and a cable insulation (12, 122) surrounding the conductor (11, 112), comprising:
- an insulation (2-5) comprising a field-control part (2, 4) which is transparent or translucent at least in some regions and which comprises a siloxane polymer, wherein the field-control part (2, 4) is configured to surround the cable insulation (12, 122) of the high-voltage cable (1, 22) at least partly, and wherein the siloxane polymer contains fluorophores at least in one partial zone (2a, 2b) of the field-control part(2, 4), wherein the fluorophores are covalently coupled to the siloxane polymer and/or to dielectric pigments embedded in the siloxane polymer; and
- a waveguide (51, 51w, 52), forming a part of the insulation (2-5), which is arranged such that a light signal caused by a partial discharge in the field-control part (2, 4) can be coupled from the field-control part (2, 4) into the waveguide (50).

2. The high-voltage cable accessory (100) according to claim 1, wherein the waveguide (51, 51w) is arranged at least partly in the field-control part (2, 4) and/or at least partly on a surface of the field-control part (2, 4).

3. The high-voltage cable accessory (100) according to one of the preceding claims, wherein the waveguide (51, 51w, 52) is fluorescence-doped or is covalently modified with fluorophores in the core and/or cladding.

4. The high-voltage cable accessory (100) according to one of the preceding claims, wherein the waveguide (51, 51w, 52) comprises the siloxane polymer or a further siloxane polymer.

5. The high-voltage cable accessory (100) according to one of the preceding claims, wherein the field-control part comprises a conductive deflector (4) which can be contacted with a cable shielding (13) of the high-voltage cable (1, 22), and/or wherein the deflector comprises the siloxane polymer or a further siloxane polymer.

6. The high-voltage cable accessory (100) according to one of the preceding claims, wherein the siloxane polymer contains various fluorophores, and/or wherein the fluorophores of the field-control part (2, 4) are selected such that they can convert a fraction of the light signal into radiation in a wavelength range, in which the siloxane polymer has a higher transparency than in a wavelength range of the proportion of the light signal, and/or wherein the fluorophores of the field-control part (2, 4) can be excited in a wavelength range below 500 nm, and/or wherein the fluorophores of the field-control part (2, 4) are selected and arranged in such a way that pairs of different fluorophores in the field-control part (2, 4) may act as a FRET pair.

7. The high-voltage cable accessory (100) according to one of the preceding claims, wherein a reflectivity of the dielectric pigments is greater than 0,8.

8. The high-voltage cable accessory (100) according to one of the preceding claims, wherein a mass fraction of the fluorophores is higher than 5 ppmw, and/or a concentration of the dielectric pigments is higher than 1% vol.

9. The high-voltage cable accessory (100) according to one of the preceding claims, wherein the high-voltage cable accessory is a cable junction box or a cable termination.

10. High-voltage device comprising a high-voltage cable accessory (100- 700) according to one of the preceding claims and an optical detector which is coupled to the waveguide (51, 52).

11. High-voltage device according to claim 10, further comprising a control and evaluation unit coupled to the optical detector, and/or a light source (40) connected to the control and evaluation unit which is arranged within a housing (110) of the high-voltage cable accessory (100).

12. A method for producing a high-voltage cable accessory (100-600) for the accommodation of a high-voltage cable (1 ,22) having a conductor (11, 112) adapted to conduct electrical current and a cable insulation (12, 122) surrounding the conductor (11, 112), comprising:
- formation of a field-control part (2, 4) which is transparent or translucent at least in some regions comprising a siloxane polymer;
- arrangement of the field-control part (2, 4) in a housing (110) of the high-voltage cable accessory (100), so that the field-control part (2, 4) is able to at least partially surround the cable insulation (12, 122) of the high-voltage cable; and
- arrangement of a waveguide (51, 52) in the housing (110) such that the siloxane polymer comprises, at least in a partial zone (2a, 2b) of the field-control part, fluorophores that are covalently coupled to the siloxane polymer and/or to dielectric particles embedded in the siloxane polymer, and/or dielectric pigments, and such that a light signal caused by a partial discharge in the field-control part (2, 4) can be coupled from the field-control part (2, 4) into the waveguide (51, 52).

13. The method according to claim 12, wherein the formation of the field-control part (2, 4) comprises the mixing of a siloxane system with the fluorophores and/or dielectric pigments to form a mixture; the introduction the mixture and/or a portion of the waveguide into a mold; and/or the polymerization of the mixture in the mold.

14. The Method according to claim 12 or 13, comprising the arrangement of the waveguide (51, 51w, 52) and/or of the dielectric pigments on a surface of the field-control part (2, 4).

15. Use of a siloxane polymer containing fluorophores and/or dielectric pigments as insulation (2-5) of a high-voltage device (100-700), wherein the fluorophores are covalently coupled to the siloxane polymer and/or to dielectric particles embedded in the siloxane polymer.

16. Use according to claim 15, wherein the insulation (2-5) contains a field-control part (2, 4).

## Revendications

1. Garniture de câble à haute tension (100-700) destinée à accueillir un câble à haute tension (1, 22) comprenant un conducteur (11, 112) conçu pour conduire du courant électrique et un isolant de câble (12, 122) qui entoure le conducteur (11, 112), comprenant :
- un isolant (2-5) comprenant une partie de contrôle de champ (2, 4) transparente ou translucide au moins dans certaines zones et comportant un polymère de siloxane, la partie de contrôle de champ (2, 4) étant conçue pour entourer au moins partiellement l'isolant de câble (12, 122) du câble à haute tension (1, 22) et le polymère de siloxane possédant des fluorophores au moins dans une région partielle (2a, 2b) de la partie de contrôle de champ, les fluorophores étant couplés de manière covalente au polymère de siloxane et/ou à des pigments diélectriques enrobés dans le polymère de siloxane ; et
- un guide d'ondes (51, 51W, 52) formant une partie de l'isolant (2-5), lequel est disposé de telle sorte qu'un signal lumineux causé par une décharge partielle dans la partie de contrôle de champ (2, 4) peut être injecté de la partie de contrôle de champ (2, 4) dans le guide d'ondes (50).

2. Garniture de câble à haute tension (100) selon la revendication 1, le guide d'ondes (51, 51W) étant au moins partiellement disposé dans la partie de contrôle de champ (2, 4) et/ou au moins partiellement au niveau d'une surface de la partie de contrôle de champ (2, 4).

3. Garniture de câble à haute tension (100) selon l'une des revendications précédentes, le guide d'ondes (51, 51W, 52) étant dopé en fluorescence ou modifié avec des fluorophore covalents dans l'âme et/ou l'enveloppe.

4. Garniture de câble à haute tension (100) selon l'une des revendications précédentes, le guide d'ondes (51, 51W, 52) comprenant le polymère de siloxane ou un polymère de siloxane supplémentaire.

5. Garniture de câble à haute tension (100) selon l'une des revendications précédentes, la partie de contrôle de champ possédant un déflecteur conducteur (4) qui peut être mis en contact avec un blindage de câble (13) du câble à haute tension (1, 22) et/ou le déflecteur comprenant le polymère de siloxane ou un polymère de siloxane supplémentaire.

6. Garniture de câble à haute tension (100) selon l'une des revendications précédentes, le polymère de siloxane possédant différents fluorophores et/ou les fluorophores de la partie de contrôle de champ (2, 4) étant sélectionnés de telle sorte qu'ils peuvent convertir une part du signal lumineux en rayonnement dans une plage de longueurs d'ondes dans laquelle le polymère de siloxane présente une transparente plus élevée que dans une plage de longueurs d'ondes de la part du signal lumineux et/ou les fluorophores de la partie de contrôle de champ (2, 4) pouvant être excités dans une plage de longueurs d'ondes au-dessous de 500 nm et/ou les fluorophores de la partie de contrôle de champ (2, 4) étant sélectionnés et disposés de telle sorte que des paires de fluorophores différents dans la partie de contrôle de champ (2, 4) peuvent agir en tant que paires de FRET.

7. Garniture de câble à haute tension (100) selon l'une des revendications précédentes, une réflectivité des pigments diélectriques étant supérieure à 0,8.

8. Garniture de câble à haute tension (100) selon l'une des revendications précédentes, la part massique des fluorophores étant supérieure à 5 ppmw et/ou une concentration des pigments diélectriques étant supérieure à 1 %.

9. Garniture de câble à haute tension (100) selon l'une des revendications précédentes, la garniture de câble à haute tension étant un manchon de câble ou une terminaison d'extrémité de câble.

10. Dispositif à haute tension comprenant une garniture de câble à haute tension (100-700) selon l'une des revendications précédentes et un détecteur optique qui est couplé au guide d'ondes (51, 52).

11. Dispositif à haute tension selon la revendication 10, comprenant en outre une unité de commande et d'interprétation couplée au détecteur optique et/ou une source de lumière (40) reliée à l'unité de commande et d'interprétation, laquelle est disposée à l'intérieur d'un boîtier (110) de la garniture de câble à haute tension (100).

12. Procédé de fabrication d'une garniture de câble à haute tension (100-600) destinée à accueillir un câble à haute tension (1, 22) comprenant un conducteur (11, 112) conçu pour conduire du courant électrique et un isolant de câble (12, 122) qui entoure le conducteur (11, 112), comprenant :
- formation d'une partie de contrôle de champ (2, 4) transparente ou translucide au moins dans certaines zones comportant un polymère de siloxane ;
- disposition de la partie de contrôle de champ (2, 4) dans un boîtier (110) de la garniture de câble à haute tension (100) de telle sorte que la partie de contrôle de champ (2, 4) peut entourer au moins partiellement l'isolant de câble (12, 122) du câble à haute tension (1, 22) ; et
- disposition d'un guide d'ondes (51, 52) dans le boîtier (110) de telle sorte que le polymère de siloxane possède des fluorophores au moins dans une région partielle (2a, 2b) de la partie de contrôle de champ, lesquels sont couplés de manière covalente au polymère de siloxane et/ou à des pigments diélectriques enrobés dans le polymère de siloxane, et/ou des pigments diélectriques, et qu'il peut injecter, de la partie de contrôle de champ (2, 4) dans le guide d'ondes (50), un signal lumineux causé par une décharge partielle dans la partie de contrôle de champ (2, 4).

13. Procédé selon la revendication 12, la formation de la partie de contrôle de champ (2, 4) comprenant le mélange d'un système de siloxane avec les fluorophores et/ou des pigments diélectriques pour former un mélange ; l'incorporation du mélange et/ou d'une portion du guide d'ondes dans un moule ; et/ou la polymérisation du mélange dans le moule.

14. Procédé selon la revendication 12 ou 13, comprenant la disposition du guide d'ondes (51, 51W, 52) et/ou des pigments diélectriques au niveau d'une surface de la partie de contrôle de champ (2, 4).

15. Utilisation d'un fluorophore et/ou d'un polymère de siloxane possédant des pigments diélectriques en tant qu'isolant (2-5) d'un dispositif à haute tension (100-700), les fluorophores étant couplés de manière covalente au polymère de siloxane et/ou aux particules diélectriques enrobées dans le polymère de siloxane.

16. Utilisation selon la revendication 15, l'isolant (2-5) possédant une partie de contrôle de champ (2, 4).
